Europäisches Patentamt

European Patent Office

Office européen des brevets

(11) Publication number: **0 341 788 B1**

# EUROPEAN PATENT SPECIFICATION

(45) Date of publication of patent specification: **11.08.93**   (51) Int. Cl.5: **H01L 39/14**, H01L 39/24

(21) Application number: **89201157.8**

(22) Date of filing: **05.05.89**

(54) **High-current-density superconductor thin films and methods for their production.**

(30) Priority: **13.05.88 IT 2056488**

(43) Date of publication of application:
**15.11.89 Bulletin 89/46**

(45) Publication of the grant of the patent:
**11.08.93 Bulletin 93/32**

(84) Designated Contracting States:
**AT BE CH DE ES FR GB GR LI LU NL SE**

(56) References cited:

**PHYSICAL REVIEW LETTERS, vol. 58, no. 25, 22nd June 1987, pages 2684-2686, American Physical Society, New York, US; P. CHAUD-HARI et al.: "Critical-current measurements in epitaxial films of YBa2Cu3O7-x compound"**

**APPLIED PHYSICS LETTERS, vol. 51, no. 11, 14th September 1987, pages 858-860, American Institute of Physics, US; B.Y. TSAUR et al.: "Preparation of superconducting YBa2Cu3Ox thin films by oxygen annealing of multilayer metal films"**

**JOURNAL OF CRYSTAL GROWTH, vol. 85, 1987, pages 585-587, Elsevier Science Pub-lishers B.V., Amsterdam, NL; G. BALESTRINO et al.: "Growth of single crystals of the high-temperature superconductor YBa2Cu3O7-x"**

(73) Proprietor: **ENICHEM S.p.A.**
**Via Mozart 1**
**I-20122 Milano(IT)**

(72) Inventor: **Romeo, Nicola**
**of Viale Santa Croce 7**
**I-43100 Parma(IT)**

(74) Representative: **Roggero, Sergio et al**
**Ing. Barzanò & Zanardo Milano S.p.A. Via Borgonuovo 10**
**I-20121 Milano (IT)**

Rank Xerox (UK) Business Services
(3.10/3.6/3.3.1)

## Description

The present invention relates to a thin-film superconductor device, characterized by high critical temperatures and a high current density, and to the processes for preparing it.

The advantages which the thin-film, ceramic type, "high-$T_c$" superconductors show, as compared to the three-dimensional, viz. "bulk" superconductors, as prepared according to the method described by P.H. Hor et al., Phys. Rev. Lett., 58 - (9), March 2nd, 1987, is that of accepting a high current flow density without losing their characteristics of superconductivity.

More particularly, the basic parameters which characterize a superconductor are:
- the critical current density ($J_c$);
- the critical magnetic field ($H_c$);
- the critical temperature ($T_c$).

Above these values, properly denominated the "critical values", the superconductor undergoes the phase transition, and turns into a normal conductor material.

As disclosed by B. Oh et al., Appl. Phys. Lett, 51 (11), Sept . 14th, 1987, the electrical and magnetic characteristics of the thin-film superconductor devices mainly depend on the microstructure of the superconductor layer, and on the substrate used in order to achieve the growth thereof.

Thin films prepared by means of the usual techniques of direct-current sputtering in a magnetic field, as described by M. Gurvitch and A.T. Fiory, Appl. Phys. Lett., 51 (3), Sept. 28th, 1987, when are grown on an amorphous substrate, such as $Al_2O_3$, show a superconductor layer with an amorphous structure, with a $J_c$ of 10 amperes/cm$^2$, as measured at 4.2 K.

In order to improve the microstructure of the superconductor layer, and, therefore, the performance of the devices incorporating such a layer, in the art structures were proposed, which are based on single-crystal structures, obtainable by means of such methods as the crystal growth in solution, very expensive and not easy to be applied at an industrial level.

According to the papers by B.Y. Tsaun et al., Appl. Phys. Lett., 51 (11), Sept. 14th, 1987, B. Oh et al., Appl. Phys. Lett., 51 (11), Sept. 14th, 1987, and P. Chaudhari et al., Appl. Phys. Rev. Lett., 58 - (25), June 22nd, 1987, the deposition of the superconductor layer of $YBa_2Cu_3O_{7-x}$ is carried out by means of well-known sputtering and evaporation methods, and the large-crystal, polycrystalline structure of the layer is obtained by epitaxy on a single crystal of $SrTiO_3$ or of $ZrO_2$.

By means of such a device, the critical current density ($J_c$) of the superconductor can reach values of at least 10$^6$ amperes/cm$^2$, as measured at 4.2 ° K.

On the basis of such a state of the prior art, the purpose of the present invention is a thin-film superconductor device, characterized by high critical temperatures and a high critical current density ($J_c$),which can be obtained by means of a particular type of sputtering, denominated as "CGTFC" (concentration gradient thin film crystallization), which makes it possible that the best orientated, polycrystalline morphologies be obtained in a thin film by starting from an even amorphous layer.

The above cited method is rapid, cheap, easily transferred to an industrial level, and generates thin films with large grains of $YBa_2CU_3O_{7-x}$ endowed with excellent superconducting properties.

The present Applicant has also found, according to the present invention, that on an even amorphous layer, and by means of the CGTFC method, a polycrystalline layer of a binary alloy of two different elements, capable of forming a homogeneous solid solution, can be formed.

The present Applicant was also able to find that on such a layer, a polycrystalline layer formed by metal oxides, and then a superconductor layer of $YBa_2Cu_3O_{7-x}$ can be deposited according to the normal techniques of deposition, and can be then grown by epitaxial or quasi-rheotaxial growth, with the polycrystalline morphology of the first layer being thus duplicated.

The superconducting phase is evidenced after that the film has undergone an annealing under an $O_2$ atmosphere, at a temperature of about 800 ° C.

The present Applicant has finally observed, according to experimental tests they carried out at the University of Milan, that such a superconductor device is endowed with good characteristics of superconductivity at temperatures higher than the temperature of liquefaction of nitrogen (77 K), and which can hence be easily reached.

In accordance therewith, according to a first aspect thereof, the present invention relates to a thin-film superconductor device, endowed with good characteristics of superconductivity at temperature higher than 77 ° K, which comprises:

a) a substrate,
on which the following are deposited in succession:
b) a layer formed by a polycrystalline alloy;
c) a polycrystalline layer formed by metal oxides;
d) a superconductor layer;
- with said (a) substrate being preferably constituted by quartz or alumina;
- with said (b) polycrystalline layer being a homogeneous binary alloy of two different elements, having a polycrystalline structure with a preferential orientation;

- with said (c) polycrystalline layer formed by metal oxides, used as a crystalline buffer, having a structure compatible with the superconductor film;
- with said (d) superconductor layer being a material of the type of

$$YBa_2Cu_3O_{7-x},$$

with

$$0 < x < 0.5$$

and having a polycrystalline structure with a preferential orientation.

The elements of the (b) layer, capable of forming solid solutions, are preferably selected from the group consisting of copper, silver and gold.

Furthermore, the selection of the materials which form the above said alloy is conditioned by:
- the similarity of the polycrystalline structure of the element of the (b) layer and of the polycrystalline structure of the successive (c) layer;
- the similarity of the characteristics of heat expansion of adjacent overlapping layers.

By using metal alloys, the considerable advantage is achieved that both of the above requisites can be met, with the device being prevented from undergoing breakages during the step of high-temperature annealing and the subsequent cooling.

According to another aspect thereof, the present invention relates to a process for preparing the above disclosed superconductor device, which comprises:
- the deposition, by heat-evaporation under vacuum, or sputtering, of a first element, in the form of an amorphous or microcrystalline layer, on an the (a) substrate;
- the deposition, on the so-formed first layer, by the same deposition techniques, of a second element having a lower melting temperature than the first element, and capable of forming a homogeneous solid solution with said first element, by operating under a constant, or substantially constant, temperature higher than the melting temperature of the second element, and close to, but lower than, the melting temperature of the first element, so as to cause the first element to gradually melt in the form of a liquid alloy with the second element, and to crystallize in the form of a solid, binary and homogeneous alloy, with a (b) polycrystalline layer being formed;
- the deposition, on the so-formed (b) polycrystalline layer, of a (c) polycrystalline layer formed by metal oxides, by heat-evaporation under vacuum, or sputtering, and its epitaxial or quasi-rheotaxial growing, in the form of a polycrystalline layer of metal oxides compatible with the successive superconductor layer;
- the completion of the device by means of the further deposition of the superconductor layer, by sputtering combined with conditions of epitaxy or of quasi-rheotaxy, so as to duplicate the morphology of the underlying layer in the superconductor layer under way of formation;
- the annealing of the film under an $O_2$ atmosphere at a temperature of about 800° C.

In the preferred form of practical embodiment of the present invention, in the formation of the (b) layer, the process is carried out with two metals, the melting points of which are different from each other by at least 50° C, and the deposition of the second element is carried out at a temperature lower than the melting temperature of the first element.

The (a) substrate useful for the superconductor device according to the present invention can be a support of quartz or of alumina.

The (b) layer of the superconductor device according to the present invention is a polycrystalline metal layer consisting of a homogeneous binary alloy of two metals having melting points different from each other, capable of forming a homogeneous solid solution.

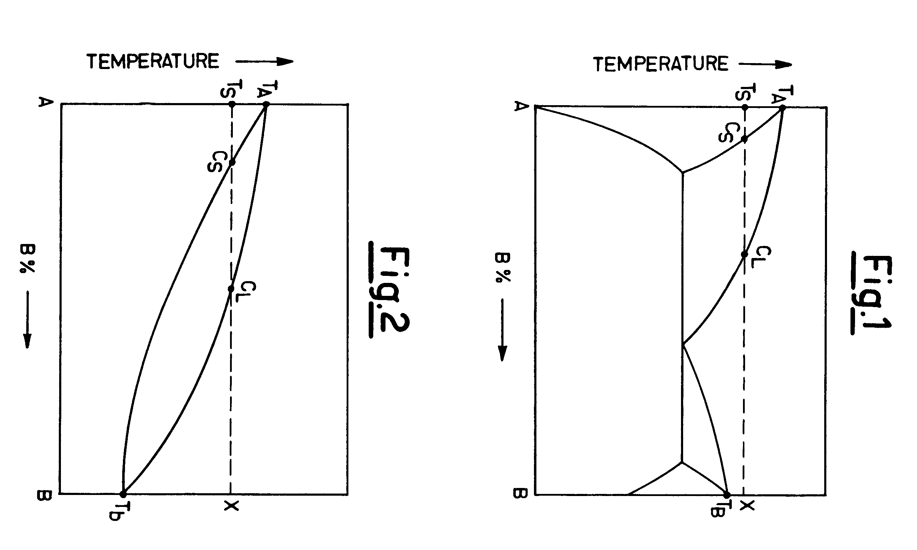

The metal pairs which are useful for the intended purpose are those which show solid/liquid phase diagrams of the types as shown in Figures 1 and 2 of the hereto attached drawing tables.

More particularly, in Figure 1 a phase diagram is reported, which relates to compositions consisting of an (A) element with a higher melting element, and a (B) element having a lower melting point, in which the solidification point of such compositions passes through a minimum value.

The procedure for the preparation of the (b) metal layer is as follows:

A few $\mu$m(microns) of the element (A) is deposited on the (a) amorphous substrate, by operating with a substrate temperature at which the metal (A) grows in an either amorphous or microcrystalline form.

The temperature is then increaed up to a value $T_s$ close to, but lower than, the temperature $T_A$ at which the element (A) melts (Figure 1). Under these conditions, such an amount of element (B) is deposited, that the end composition is a homogeneous solid solution, i.e., within the $T_s$-$C_s$ region.

When the first layers of element (B) are deposited above the layer of element (A), they interact with the surface of element (A), forming a liquid surface alloy having a composition comprised within the region of $C_L$-X. Therefore, a concentration gradient between the mass of element (A) and the liquid alloy (A + B) is formed at its surface. This concentration gradient causes the solid to diffuse inside the liquid, until the selected concentration within the $T_s$-$C_s$ region is reached.

By means of such a treatment, most of element (A) melts and crystallizes in the form of a homogeneous solid solution, i.e., a binary alloy (A + B).

Metal pairs useful in the preparation of the (b) layer are also those which show a solid/liquid phase diagram of the type as shown in Figure 2, in which the solidification point of the compositions has an intermediate value between those of the components in the pure state.

The symbols reported in Figure 2 have the same meaning as of those reported in Figure 1, and the same considerations are valid for it, which are hereinabove reported as regards Figure 1.

According to the present invention, the (c) polycrystalline layer formed by metal oxides such as $SnTiO_3$ or $ZnO_2$ for example is deposited above the (b) layer by heat-evaporation under vacuum or sputtering, and is caused to grow by epitaxial growth at a temperature lower than the melting temperature of the (b) layer, or according to a growing mode similar to a quasi-rheotaxial growth mode, at a temperature close to the melting temperature of the (b) layer, i.e., under conditions of substrate "mobility".

According to the present invention, on the (c) layer a (d) superconductor layer is deposited and, in order to complete the device, the same device is submitted to a high-temperature annealing under an $O_2$ atmosphere (at about 800°C).

The material used for the (d) layer is $YBa_2Cu_3O_{7-x}$. The (d) layer is advantageously formed by heat-evaporation under vacuum or sputtering, which preserves the preferential orientation of the crystals, followed by an annealing under an $O_2$ atmosphere at a temperature of about 800°C, in order to form the orthorombic superconducting phase.

The sputtering technique is particularly well-suited for preparing films of polynary materials, in that it makes it possible the material to be transferred from the target to the substrate without considerable changes occurring in stoichiometric relationships.

In fact, the superconductor operates only if the target, formed by Y, Ba, Cu and O, shows a stoichiometric composition of these elements.

The suitable amount of material, obtained by sputtering, will be hence deposited on the substrate in a quasi-ideal composition for the device to properly operate.

Furthermore, the sputtering in the presence of $O_2$ allows any possible losses of this element - which, even if reactive, is extremely volatile - to be compensated for.

The films of $YBa_2Cu_3O_{7-x}$ can be prepared by sputtering according to three different routes:

1) by using one single target, prepared by hot-pressing the three oxides which compose the material, in such a way that the composition of the film can be varied by using different targets of various compositions. The preparation of the device takes place on a substrate of $Al_2O_3$ by using a target having the composition:

$0.5\ Y_2O_3,\ 2\ BaO,\ 3\ CuO.$

The super-conducting phase evidenced after that the film has undergone an annealing under $O_2$ at a temperature of about 800°C, is detected by X rays;

2) by using three separate targets of $Y_2O_3$, BaO, and CuO, and sequentially depositing controlled thicknesses of said three oxides. The phase of $YBa_2Cu_3O_{7-x}$ is then obtained by means of the diffusion and reaction of said three oxides, with an annealing under $O_2$ at a high temperature (about 800°C);

3) by means of a sputtering system, in which the possibility exists that the three targets be operated simultaneously, under controlled sputtering rates, and the substrate simultaneously revolves over the targets at a controlled speed.

The thin-film superconductor device according to the present invention displays the advantages to be achieved when even amorphous (a) substrates, such as quartz and alumina, are used, which are are not endangered by the high temperatures of the annealing step, and are cheap; as well as the advantages of requiring such standard deposition techniques, as the heat-evaporation under vacuum and sputtering.

The (d) superconducting layer of said device is constituted by polycrystals having a preferential orientation, based on the use of amorphous supports, and prepared by duplication, by means of standard deposition techniques (heat-evaporation under vacuum and sputtering) of particular layers, such as CGTFC.

According to the present invention, the (c) polycrystalline layer is formed by crystallized metal films used as substrates for the superconductor material $YBa_2Cu_3O_{7-x}$, and with which they have to be compatible.

## Claims

1. Thin-film, high current density superconductor device having high critical temperatures, which comprises:

   a) a substrate, on which the following are deposited in succession:

b) a layer formed by a polycrystalline alloy;

c) a polycrystalline layer formed by metal oxides;

d) a ceramic superconductor layer;

- with said (b) polycrystalline layer being a homogeneous binary alloy of two elements having melting points different from each other, and having a polycrystalline structure with a preferential orientation;

- with said (c) polycrystalline layer formed by metal oxides, used as crystalline buffers, having a structure compatible with the superconductor film;

- with said (d) superconductor layer being a layer of

$$YBa_2Cu_3O_{7-x}, \text{ with } 0 < x < 0.5$$

having a polycrystalline structure with a preferential orientation.

2. Device according to claim 1, endowed with superconductivity at temperature higher than or equal to 77 K.

3. Device according to claim 1, characterized in that the (a) substrate is either an amorphous substrate, or a crystalline substrate.

4. Device according to claim 1, characterized in that the binary alloy of the (b) layer is formed by a pair of metals, the components of which are selected from the following metals: copper, silver and gold.

5. Device according to claim 1, characterized in that said (c) polycrystalline layer is formed by metal oxides compatible with the (d) superconductor layer, preferably $SrTiO_3$ or $ZrO_2$, used as crystalline buffers for the superconductor layer.

6. Process for preparing the superconductor device according to claims from 1 to 5, characterized in that:

- a first element is deposited, by heat-evaporation under vacuum, or sputtering, in the form of an amorphous or microcrystalline layer, on the (a) substrate;

- on the so-formed first layer a second element is deposited by the same deposition techniques, which has a lower melting temperature than the first element and is capable of forming a homogeneous solid solution with said first element, said deposition being done at a constant temperature higher than the melting temperature of the second element, and close to, but lower than, the melting temperature of the first element, so as to cause the first element to gradually melt in the form of a liquid alloy with the second element, and to crystallize in the form of a solid, binary and homogeneous alloy, with a (b) polycrystalline layer being formed;

- on the so-formed (b) polycrystalline layer, a (c) polycrystalline layer formed by metal oxides is deposited by sputtering, or of heat-evaporation under vacuum, and said (c) layer is grown in epitaxial or quasi-rheotaxial growing mode, in the form of a polycrystalline layer of metal oxides;

- the device is completed by means of the further deposition of the (d) superconductor layer, by sputtering combined with conditions of epitaxy or of quasi-rheotaxy, so as to duplicate the morphology of the underlying layer in the superconductor layer under way of formation;

- annealing the film under an $O_2$ atmosphere at a temperature of about 800 °C is performed.

7. Process according to claim 6, characterized in that in the formation of the (b) layer, the process is carried out with two metals, the melting points of which are different from each other by at least 50 °C, and the deposition of the second element is carried out at a temperature lower than the melting temperature of the first element.

**Patentansprüche**

1. Dünnschicht-Supraleiteranordnung mit hoher Stromdichte und hohen kritischen Temperaturen, welche Anordnung umfaßt:

a) ein Substrat, auf welchem die nachfolgenden Schichten aufeinanderfolgend abgelagert sind:

b) eine aus einer polykristallinen Legierung gebildete Schicht;

c) eine aus Metalloxiden gebildete polykristalline Schicht;

d) eine keramische Supraleiterschicht;

- wobei die genannte polykristalline Schicht (b) eine homogene binäre Legierung von zwei Elementen mit voneinander unterschiedlichen Schmelzpunkten ist und eine polykristalline Struktur mit einer bevorzugten Orientierung aufweist;

- wobei die polykristalline Schicht (c) aus Metalloxiden gebildet ist, die als kristalline Puffer verwendet werden und eine mit dem Supraleiterfilm verträgliche Struktur aufweisen;

- wobei die Supraleiterschicht (d) eine Schicht aus

$YBa_2Cu_3O_{7-x}$

ist,
worin 0<x<0,5 ist und eine polykristalline Struktur mit einer bevorzugten Orientierung vorliegt.

2. Anordnung nach Anspruch 1, ausgestattet mit Supraleitfähigkeit bei einer Temperatur von größer oder gleich 77 K.

3. Anordnung nach Anspruch 1, dadurch gekennzeichnet, daß das Substrat (a) entweder ein amorphes Substrat oder ein kristallines Substrat ist.

4. Anordnung nach Anspruch 1, dadurch gekennzeichnet, daß die binäre Legierung der Schicht (b) aus einem Elementenpaar gebildet ist, deren Komponenten unter den folgenden Metallen: Kupfer, Silber und Gold ausgewählt sind.

5. Anordnung nach Anspruch 1, dadurch gekennzeichnet, daß die polykristalline Schicht (c) aus mit der Supraleiterschicht (d) verträglichen Metalloxiden, vorzugsweise $SrTiO_3$ oder $ZrO_2$, gebildet ist, die als kristalline Puffer für die Supraleiterschicht verwendet werden.

6. Verfahren zur Herstellung der Supraleiteranordnung nach den Ansprüchen 1 bis 5, dadurch gekennzeichnet, daß:
   - auf dem Substrat (a) durch Hitzeverdampfung unter Vakuum oder durch Sputtern ein erstes Element in Form einer amorphen oder mikrokristallinen Schicht abgelagert wird;
   - auf der so gebildeten ersten Schicht nach den gleichen Ablagerungsmethoden ein zweites Element abgelagert wird, das eine niedrigere Schmelztemperatur als das erste Element aufweist und zur Ausbildung einer homogenen festen Lösung mit diesem ersten Element befähigt ist, welche Abscheidung bei einer konstanten, über der Schmelztemperatur des zweiten Elementes und nahe bei, aber niedriger als der Schmelztemperatur des ersten Elementes liegenden Temperatur vorgenommen wird, sodaß das erste Element zu einem schrittweisen Schmelzen in Form einer flüssigen Legierung mit dem zweiten Element und zum Kristallisieren in Form einer festen, binären und homogenen Legierung gebracht wird, unter Ausbildung einer polykristallinen Schicht (b);
   - auf der so gebildeten polykristallinen Schicht (b) eine aus Metalloxiden gebildete polykristalline Schicht (c) durch Sputtern oder Hitzeverdampfung unter Vakuum abgelagert wird und diese Schicht (c) im epitaxialen oder quasirheotaxialen Wuchsmodus in Form einer polykristallinen Schicht aus Metalloxiden wachsen gelassen wird,
   - die Anordnung durch die weitere Ablagerung der Supraleiterschicht (d) durch Sputtern, kombiniert mit Bedingungen einer Epitaxie oder Quasi-Rheotaxie, vervollständigt wird, um die Morphologie der darunter liegenden Schicht in der in Bildung begriffenen Supraleiterschicht zu duplizieren;
   - der Film unter einer Sauerstoffatmosphäre bei einer Temperatur von etwa 800 °C geglüht wird.

7. Verfahren nach Anspruch 6, dadurch gekennzeichnet, daß bei der Ausbildung der Schicht (b) das Verfahren mit zwei Metallen vorgenommen wird, deren Schmelzpunkte sich um wenigstens 50 °C voneinander unterscheiden, und daß die Ablagerung des zweiten Elementes bei einer niedrigeren Temperatur als der Schmelztemperatur des ersten Elementes vorgenommen wird.

**Revendications**

1. Dispositif supraconducteur en couche mince, à densité de courant élevée et présentant une température critique élevée, qui comporte :
   a) un substrat, sur lequel sont déposées successivement les couches suivantes :
   b) une couche formée d'un alliage polycristallin ;
   c) une couche polycristalline formée d'oxydes métalliques ;
   d) une couche de supraconducteur céramique ;
   - ladite couche polycristalline (b) étant constituée d'un alliage binaire homogène de deux éléments présentant des points de fusion différents l'un de l'autre, et présentant une structure polycristalline dotée d'une orientation préférentielle ;
   - ladite couche polycristalline (c) étant formée d'oxydes métalliques, utilisés comme tampons cristallins, et présentant une structure compatible avec le film supraconducteur ;

- ladite couche de supraconducteur (d) étant une couche de YBa$_2$Cu$_3$O$_{7-x}$, où 0 < x < 0,5, présentant une structure polycristalline dotée d'une orientation préférentielle.

**2.** Dispositif conforme à la revendication 1, doté d'une supraconductivité à des températures supérieures ou égales à 77°K.

**3.** Dispositif conforme à la revendication 1, caractérisé en ce que le substrat (a) est soit un substrat amorphe, soit un substrat cristallin.

**4.** Dispositif conforme à la revendication 1, caractérisé en ce que l'alliage binaire de la couche (b) est formé d'une paire de métaux dont les constituants sont choisis parmi les métaux suivants : cuivre, argent et or.

**5.** Dispositif conforme à la revendication 1, caractérisé en ce que ladite couche polycristalline (c) est formée d'oxydes métalliques compatibles avec la couche de supraconducteur (d), et de préférence de SrTiO$_3$ ou de ZrO$_2$, utilisés comme tampons cristallins pour la couche de supraconducteur.

**6.** Procédé de préparation d'un dispositif supraconducteur conforme aux revendications 1 à 5, caractérisé en ce que :

- on dépose un premier élément, par évaporation thermique sous vide ou par pulvérisation, sous la forme d'une couche amorphe ou microcristalline, sur le substrat (a) ;
- sur la première couche ainsi formée, on dépose, par les mêmes techniques de dépôt, un second élément qui présente une température de fusion inférieure à celle du premier élément et qui est capable de former une solution solide homogène avec ce premier élément, ladite opération de dépôt étant effectuée à une température constante, supérieure à la température de fusion du second élément et voisine de la température de fusion du premier élément, mais inférieure à celle-ci, de façon à provoquer la fusion graduelle du premier élément, sous la forme d'un alliage liquide avec le second élément, et à faire cristalliser un alliage binaire solide et homogène, en formant ainsi une couche polycristalline (b) ;

- sur la couche polycristalline (b) ainsi formée, on dépose une couche polycristalline (c) formée d'oxydes métalliques, par pulvérisation ou par évaporation thermique sous vide, et l'on fait croître ladite couche (c) en mode de croissance épitaxial ou quasi-rhéotaxial, sous la forme d'une couche polycristalline d'oxydes métalliques ;
- on complète le dispositif par le dépôt ultérieur de la couche de supraconducteur (d), par pulvérisation et dans des conditions d'épitaxie ou de quasi-rhéotaxie, de façon à reproduire la morphologie de la couche sous-jacente dans la couche de supraconducteur en train d'être formée ;
- on fait subir au film un recuit sous atmosphère d'oxygène et à une température d'environ 800°C.

**7.** Procédé conforme à la revendication 6, caractérisé en ce que, au cours de la formation de la couche (b), on réalise ce procédé avec deux métaux dont les points de fusion diffèrent l'un de l'autre d'au moins 50°C, et l'on réalise le dépôt du second élément à une température inférieure à la température de fusion du premier élément.

# Fig.1

# Fig.2